# EUROPEAN PATENT APPLICATION

(11) **EP 2 910 615 A1**
(43) Date of publication of application: **26.08.2015**
(21) Application number: 13846923.4
(22) Date of filing: 15.10.2013
(51) Int. Cl.: C09J 7/00, B32B 27/28, B32B 27/32, C03C 27/12, C08J 5/18, C08K 5/14, C08L 23/06, C08L 31/04, C09J 11/06, C09J 123/04, C09J 131/00, H01L 31/042

(54) **CURED SHEET, LAMINATE BODY USING SAME, AND METHOD FOR PRODUCING SAID LAMINATE BODY**

(30) Priority: 17.10.2012 JP 2012229461
(71) Applicant: Bridgestone Corporation, Tokyo 104-8340 (JP)
(72) Inventor: TARUTANI Yasunori, Yokohama-shi Kanagawa 244-8510 (JP); KAGA Norihiko, Yokohama-shi Kanagawa 244-8510 (JP); KATAOKA Hisataka, Yokohama-shi Kanagawa 244-8510 (JP); INAMIYA Takato, Yokohama-shi Kanagawa 244-8510 (JP); ARAAKE Satoshi, Yokohama-shi Kanagawa 244-8510 (JP)
(74) Representative: Oxley, Robin John George
(86) International application number: PCT/JP2013/077996
(87) International publication number: WO 2014/061669

(57) **Abstract**

There is provided a cured sheet and a laminate having the same, wherein the cured sheet is prepared by curing a laminate forming sheet containing an ethylene-vinyl acetate copolymer and a polyethylene, excellent in adhesion durability and has a sufficient flexibility even in the case of a high content of the polyethylene.

A cured sheet constituting a laminate and a laminate having the same, wherein the cured sheet is prepared by curing through cross-linking a laminate forming sheet comprising a composition containing an ethylene-vinyl acetate copolymer, a polyethylene and an organic peroxide; a weight ratio of the ethylene-vinyl acetate copolymer (EVA) to the polyethylene (PE) (EVA:PE) is in a range of 3:7 to 8:2; and the cured sheet has a sea-island structure wherein the ethylene-vinyl acetate copolymer constitutes a sea phase and the polyethylene constitutes an island phase.

## Description

### Technical Field

The present invention relates to a cured sheet and a laminate having the same, wherein the cured sheet is prepared by curing a laminate forming sheet (such as a solar cell sealing film and an intermediate film for a laminated glass) for bonding integration of a laminate such as a solar cell module and a laminated glass.

### Background Art

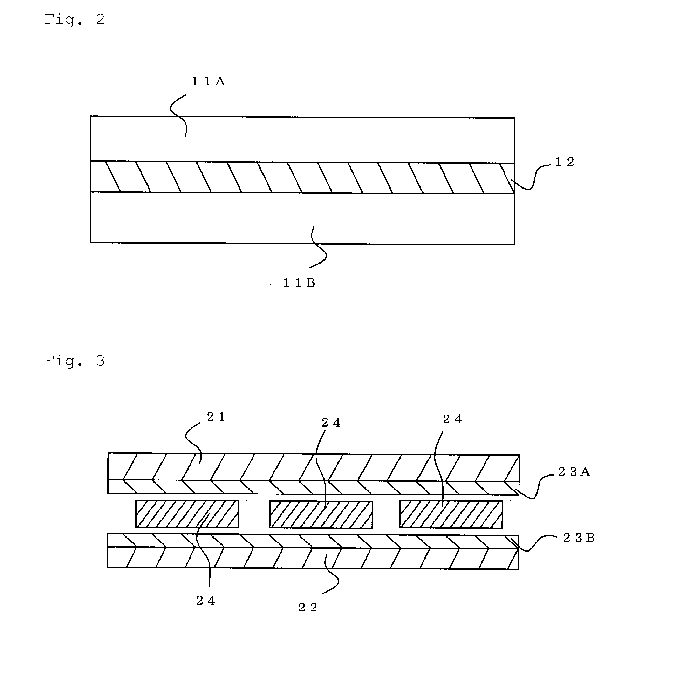

Conventionally, a sheet comprising a composition containing an ethylene-vinyl acetate copolymer (hereinafter, also referred to as EVA) as a main component (EVA sheet) has been utilized as an intermediate film for a laminated glass and a solar cell sealing film because it is inexpensive and has a high transparency. The EVA sheet as an intermediate film for a laminated glass, as shown Figure 2, is sandwiched between glass plates 11A and 11B and exerts a function such as penetration resistance and prevention of scattering of broken glass pieces. The EVA sheets as a solar cell sealing film, as shown in Figure 3, are disposed between solar cells 24 and a front side transparent protective member 21 such as a glass substrate, and between the solar cells 24 and a backside protective member (back cover) 22, respectively, and exert a function such as ensuring insulation properties and mechanical durability.

Recently, for the purpose of improving heat resistance, creep resistance and moisture-permeation resistance or the like, a composition for a sealing film or a sheet for sealing containing an ethylene copolymer such as an EVA and a polyolefin such as a polyethylene (hereinafter, also referred to as PE) has been developed (Patent Literature 1 and 2).

### Prior Art Literature

### Patent Literature

Patent Literature 1: JP A 2001-332750
Patent Literature 2: JP A 2010-059277

### Summary of Invention

### Problems to be solved by the Invention

However, according to the inventor's study, it was confirmed that when a laminate such as a solar cell module and a laminated glass is produced using a laminate forming sheet such as a solar cell sealing film and an intermediate film for a laminated glass comprising a composition in which an EVA and a polyethylene are mixed together such as that described in Patent Literature 1 or 2, particularly a laminate forming sheet having a high content of a polyethylene, the cured sheet prepared by curing the laminate forming sheet through a step of press-adhering under heating may have a lowered adhesion durability and flexibility, leading to a laminate having an insufficient durability.

Accordingly, it is an object of the present invention to provide a cured sheet, a laminate having the same, and a process for manufacturing the laminate, wherein the cured sheet is prepared by curing a laminate forming sheet containing an ethylene-vinyl acetate copolymer and a polyethylene, excellent in adhesion durability and has a sufficient flexibility even in the case of a high content of the polyethylene.

### Means for Solving the Problems

The above object is achieved by a cured sheet constituting a laminate, wherein the cured sheet is prepared by curing through cross-linking a laminate forming sheet comprising a composition containing an ethylene-vinyl acetate copolymer, a polyethylene and an organic peroxide; a weight ratio of the ethylene-vinyl acetate copolymer (EVA) to the polyethylene (PE) (EVA:PE) is in a range of 3:7 to 8:2; and the cured sheet has a sea-island structure in which the ethylene-vinyl acetate copolymer constitutes a sea phase and the polyethylene constitutes an island phase.

A cured sheet prepared by curing through cross-linking a laminate forming sheet in which an ethylene-vinyl acetate copolymer (EVA) and a polyethylene (PE) are mixed together, with a sea-island structure in which the EVA component constitutes a sea phase (continuous phase) and the PE component constitutes an island phase maintained, exerts a sufficient adhesive strength and flexibility due to the curing of the EVA through cross-linking and provides a cured sheet having an excellent adhesion durability and a sufficient hardness, compared with the case of curing in a state in which the EVA and the PE show a co-continuous structure or curing in a state in which the PE component constitutes a sea phase and the EVA component constitutes an island phase.

The preferable aspects of the cured sheet according to the present invention are as follows.
(1) An average diameter ((average major axis (l) + average minor axis (d)) / 2) of the island phase of the polyethylene is 40 µm or lees.
(2) An average aspect ratio (average major axis (l) / average minor axis (d)) of the island phase of the polyethylene is 40 or less.

These lead to a cured sheet which exerts a further adhesive strength or the like due to the curing of the EVA through cross-linking and is further excellent in adhesion durability. In addition, the blending ratio of the PE can be further increased.

(3) The weight ratio of the ethylene-vinyl acetate copolymer (EVA) to the polyethylene (PE) (EVA:PE) is in a range of 3:7 to 6:4.

(4) The cured sheet is a cured product of an intermediate film for a laminated glass or a solar cell sealing film.

Moreover, the object of the present invention can be achieved by a laminate having the cured sheet according to the present invention.

The laminate according to the present invention has the cured sheet according to the present invention having an improved heat resistance, creep resistance, moisture-permeation resistance or the like due to blending a PE in an EVA, and an adhesion durability or the like similar to that of an EVA. That is, the laminate according to the present invention is integrated by the cured sheet according to the present invention, and is extremely excellent in weatherability and durability.

The laminate according to the present invention preferably has a structure in which the cured sheet is sandwiched between at least two substrates. Such a structure is one which allows the cured sheet according to the present invention to exert adhesion durability sufficiently.

Further, the laminate according to the present invention is preferably a laminated glass or a solar cell module.

Furthermore, the object of the present invention can be achieved by a process for manufacturing the laminate according to the present invention, comprising the steps of: laminating a laminate forming sheet and another material for a laminate to form an uncured laminate, wherein the laminate forming sheet comprises a composition containing an ethylene-vinyl acetate copolymer, a polyethylene and an organic peroxide; a weight ratio of the ethylene-vinyl acetate copolymer (EVA) to the polyethylene (PE) (EVA:PE) is in a range of 3:7 to 8:2; and the laminate forming sheet has a sea-island structure in which the ethylene-vinyl acetate copolymer constitutes a sea phase and the polyethylene constitutes an island phase; and heating the uncured laminate to cure the laminate forming sheet through cross-linking, wherein the heating is performed under a temperature condition of 130 to 175°C so that a gel fraction of the ethylene-vinyl acetate copolymer in the laminate forming sheet 5 min after the initiation of heating is 15 to 70%.

In manufacturing the laminate according to the present invention, even in the case that a laminate forming sheet formed from a composition containing an EVA, a PE and an organic peroxide and having a sea-island structure in which the EVA constitutes a sea phase and the PE constitutes an island phase is used so as to obtain the cured sheet according to the present invention, the molecular diffusion of the PE in the laminate forming sheet may occur to cause the bloating of the island phase of the PE or the change of the PE to a continuous phase at a stage of heating the laminate including the laminate forming sheet to cure through cross-linking. In this case, the cured sheet according to the present invention cannot be obtained in the laminate after curing and the laminate to be obtained may have a poor weatherability and durability.

In the process for manufacturing a laminate according to the present invention, the heating temperature during the step of curing through cross-linking is set to the above range, and the increasing rate of the gel fraction is adjusted so that the gel fraction of the EVA 5 min after the initiation of heating is the above range. This enables to suppress the bloating of the island phase of the PE because the flowability of the EVA is moderately lowered when the temperature is raised to a temperature at which the molecular diffusion of the PE in the laminate forming sheet easily occurs, and a laminate having the cured sheet according to the present invention can be manufactured by further continuing heating to cure through cross-linking while maintaining the sea-island structure in which the EVA constitutes a sea phase and the PE constitutes an island phase. The increasing rate of the gel fraction of the EVA can be adjusted by the type of the organic peroxide and the amount thereof to be blended.

The preferred aspect of the process for manufacturing a laminate according to the present invention is as follows.
(1) The organic peroxide is t-butylperoxy-2-ethylhexyl monocarbonate or 2,5-dimethyl-2,5-di(tert-butylperoxy)hexane. These organic peroxides are suitable for setting the gel fraction of the EVA in the above range at the above range of heating temperature during the above heating time.
(2) A content of the organic peroxide is 0.2 to 4.0 parts by weight based on 100 parts by weight of the ethylene-vinyl acetate copolymer.

### Effects of Invention

According to the present invention, a cured sheet such as a cured product of an intermediate film for a laminated glass and that of a solar cell sealing film having an improved heat resistance or the like, being excellent in adhesion durability and having a sufficient flexibility can be obtained by blending a PE in an EVA. Therefore, a laminate such as a laminated glass and a solar cell module having the cured sheet according to the present invention is a laminate extremely excellent in weatherability and durability.

### Brief Description of Drawings

Figure 1 is a schematic cross-sectional view for illustrating the sea-island structure of the cured sheet according to the present invention.
Figure 2 is a schematic cross-sectional view of a general laminated glass.
Figure 3 is a schematic cross-sectional view of a general solar cell module.

### Mode for carrying out the Invention

### [Cured Sheet]

Hereinafter, the cured sheet according to the present invention will be described referring to the drawings.

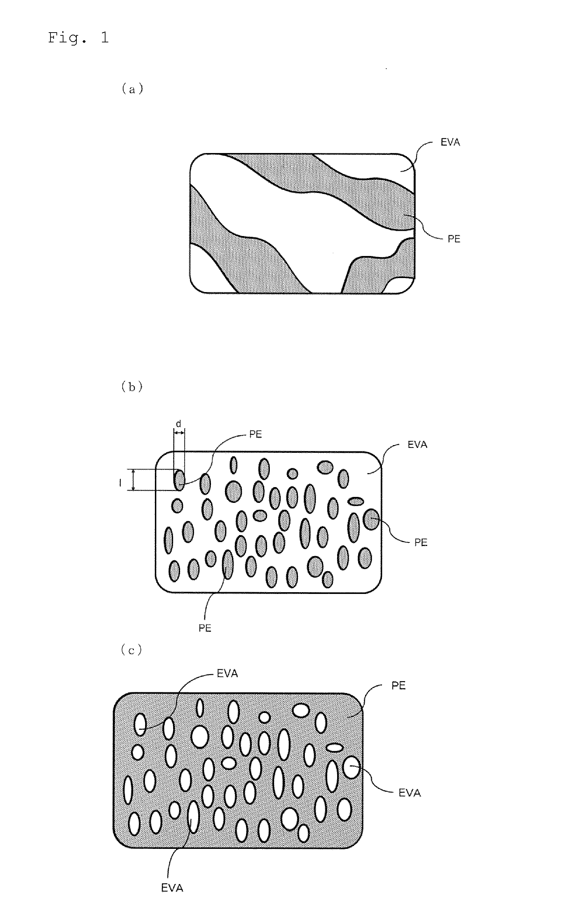

Figure 1 is a schematic cross-sectional view for illustrating the sea-island structure of the cured sheet according to the present invention, Figure 1 (a) shows a state in which the EVA and the PE form a co-continuous structure, Figure 1 (b) shows a state of a sea-island structure in which the EVA constitutes a sea phase (continuous phase) and the PE constitutes an island phase, and Figure 1 (c) shows a state of a sea-island structure in which the PE component constitutes a sea phase and the EVA component constitutes an island phase.

In the case of a cured sheet prepared by curing through cross-linking a laminate forming sheet comprising a resin composition containing an EVA and a PE with a cross-linking agent such as an organic peroxide, the sheet may be cured in a state in which the EVA component and the PE component have a co-continuous structure as shown in Figure 1 (a), in a state having a sea-island structure in which the EVA component constitutes a sea phase and the PE component constitutes an island phase as shown in Figure 1 (b), or in a state having a sea-island structure in which the PE component constitutes a sea phase and the EVA component constitutes an island phase as shown in Figure 1 (c). As described below, these may vary depending on the blending ratio of the EVA to the PE in the resin composition in manufacturing a laminate forming sheet, the mixture state thereof, the type and the amount of the organic peroxide to be blended, the temperature conditions for curing through cross-linking and the like.

The cured sheet according to the present invention is characterized in that the weight ratio of the EVA to the PE (EVA:PE) is in a range of 3:7 to 8:2, and the EVA and the PE are cured in a state of a sea-island structure in which the EVA component constitutes a sea phase and the PE component constitutes an island phase as shown in Figure 1 (b). In the case where the blending ratio of the PE is within the above range, the above states shown in Figure 1 (a) to (c) may be formed depending on manufacturing conditions for a laminate forming sheet or conditions for curing through cross-linking as described above. Among them, the cured sheet that has been cured through cross-linking in the state according to the present invention (Figure 1 (b)) can exert a sufficient adhesive strength and flexibility due to the curing of the EVA through cross-linking, compared with the cured sheet that has been cured in a state in which the EVA and the PE form a co-continuous structure as shown in Figure 1 (a) and the cured sheet that has been cured in a state of a sea-island structure in which the PE component constitutes a sea phase and the EVA component constitutes an island phase as shown in Figure 1 (c), and therefore there can be provided a cured sheet being excellent in adhesion durability and having a sufficient flexibility.

In the cured sheet according to the present invention, the form (shape, size, etc.) of the island phase of the PE constituting the sea-island structure is not particularly limited. Examples of the shape of the island phase as a cross-sectional shape include circles, ellipses, polygons such as rectangles, round polygons such as round rectangles, and a shape in combination thereof. Regarding to the size of the island phase, when the average value between the average major axis (l) and the average minor axis (d) of the island phase is defined as the average diameter in the cross-sectional shape illustrated as circles or ellipses in Figure 1 (b) as an example, the average diameter ((average major axis (l) + average minor axis (d)) / 2) of the island phase of the PE is preferably 40 µm or less. This enables to exert a further adhesive strength or the like due to the curing of the EVA through cross-linking. In addition, a cured product having a further higher blending ratio of the PE can be obtained by compacting the island phase. The average diameter of the island phase is further preferably 30 µm or less, and particularly preferably 20 µm or less. The lower limit value is preferably 1 µm or more, and further preferably 3 µm or more. When the size of the island phase is too large, a nature similar to a co-continuous structure may occur to lower the adhesion durability of the cured product, and when being too small, the viscosity of the sheet before curing may increase to lower workability.

Regarding to the average diameter of the island phase in the case where the cross-sectional shape of the island phase is polygons, round polygons or the like, the average major axis (l) and the average minor axis (d) are calculated, defining the maximum distance in the longitudinal direction as the major axis and the maximum distance in the width direction as the minor axis, respectively.

Moreover, when the average aspect ratio (average major axis (l) / average minor axis (d)) of the island phase of the PE is too large, a nature similar to a co-continuous structure may occur to lower the adhesion durability of the cured product and therefore the average aspect ratio of the island phase is preferably 40 or less. This can provide a cured product having a higher blending ratio of the PE. The average aspect ratio of the island phase is more preferably 1 to 20, further preferably 1 to 10, and particularly preferably 1 to 5.

These numerical values can be calculated by measuring an island phase in a portion arbitrarily sampled in a picture of the cross-section of a resin composition magnified by 1000 times, etc., with a transmission electron microscope, or in a picture of the cross-section of a resin composition obtained by elastic modulus mapping with an AFM (atomic force microscope).

In the cured sheet according to the present invention, the weight ratio of the EVA to the PE (EVA:PE) is 3:7 to 8:2; however, the blending ratio of the PE is preferably high because an effect of improving heat resistance, creep resistance and moisture-permeation resistance, or the like due to blending a PE can be sufficiently obtained and an effect of an excellent adhesion durability or the like due to the above sea-island structure can be obtained. Accordingly, the EVA:PE is preferably 3:7 to 4:6, and particularly preferably 3:7 to 5:5.

The cured sheet according to the present invention may be one for any application as long as it is a cured sheet which is used for forming a laminate and bonding integrates the laminate. In particular, a cured sheet used in the outdoor environment, for which weatherability and durability are required, is preferable and a cured product of an intermediate film for a laminated glass or a solar cell sealing film is particularly preferable. The details about these applications will be discussed below.

### [Laminate]

The cured sheet according to the present invention constitutes a laminate and is a cured product that has been cured as a part of a laminate. Accordingly, the present invention also relates to a laminate having the cured sheet according to the present invention.

The laminate according to the present invention may have any structure as long as it has the cured sheet according to the present invention, and is a laminate in which various materials for a laminate such as substrates and coating layers are appropriately combined and bonding integrated. It is preferable that the laminate have a structure in which the cured sheet according to the present invention is sandwiched between at least two substrates because the adhesion durability of the cured sheet according to the present invention is sufficiently exerted. The details about these applications will be discussed below.

### [Process for Manufacturing Laminate]

The laminate according to the present invention has the cured sheet according to the present invention, and therefore in manufacturing the laminate according to the present invention, it is necessary to perform a manufacturing process such that the cured sheet according to the present invention can be obtained. In order to obtain the cured sheet according to the present invention having a sea-island structure in which the EVA component constitutes a sea phase and the PE component constitutes an island phase, a laminate forming sheet (uncured) comprising a composition containing an EVA, a PE and an organic peroxide is usually manufactured so that the laminate forming sheet also has a similar sea-island structure. However, even when a laminate forming sheet having a sea-island structure in which the EVA constitutes a sea phase and the PE constitutes an island phase is used, the molecular diffusion of the PE in the laminate forming sheet may occur to cause the bloating of the island phase of the PE or the change of the PE to a continuous phase at a stage of heating the laminate including the laminate forming sheet to cure through cross-linking. In this case, the cured sheet according to the present invention cannot be obtained in the laminate after curing and the laminate to be obtained may have a poor weatherability and durability.

Therefore, the process for manufacturing a laminate according to the present invention comprises the steps of: laminating a laminate forming sheet and another material for a laminate (e.g., a substrate such as a glass board, a protective member and a solar cell) to form an uncured laminate, wherein the laminate forming sheet comprises a composition containing an ethylene-vinyl acetate copolymer, a polyethylene and an organic peroxide; a weight ratio of the ethylene-vinyl acetate copolymer (EVA) to the polyethylene (PE) (EVA:PE) in a range of 3:7 to 8:2 (preferably 3:7 to 4:6 and further preferably 3:7 to 5:5); and the laminate forming sheet has a sea-island structure in which the ethylene-vinyl acetate copolymer constitutes a sea phase and the polyethylene constitutes an island phase; and heating the uncured laminate to cure the laminate forming sheet through cross-linking, wherein the heating is performed under a temperature condition of 130 to 175°C so that a gel fraction of the ethylene-vinyl acetate copolymer in the laminate forming sheet 5 min after the initiation of heating becomes 15 to 70%.

Setting the heating temperature in the step of curing the uncured laminate through cross-linking to 130 to 175°C enables to shorten the time for the cross-linking step to improve the productivity, and adjusting the increasing rate of the gel fraction of the EVA so that the gel fraction of the EVA 5 min after the initiation of heating becomes 15 to 70% enables to moderately lower the flowability of the EVA when the temperature of the laminate forming sheet is raised to a temperature at which the molecular diffusion of the PE in the sheet easily occurs (100°C to 120°C).

This lowered flowability of the EVA can prevent the molecular diffusion of the PE and suppress the bloating of the island phase of the PE or the change thereof to a continuous phase. In the case where the gel fraction of the EVA 5 min after the initiation of heating is less than 15%, the bloating of the PE cannot be inhibited, and in the case of more than 70%, the cross-linking may proceed too quickly to cause foaming. The gel fraction 5 min after the initiation of heating is preferably 25 to 60%.

Thereafter, by further continuing heating at the above temperature to cure the sheet through cross-linking, a laminate having the cured sheet according to the present invention can be manufactured while maintaining the sea-island structure in which the EVA constitutes a sea phase and the PE constitutes an island phase. The gel fraction of the EVA after curing through cross-linking is preferably 80% or more. The heat treatment may be performed under an increased pressure. In this case, it is preferable to perform the heat treatment while pressuring the laminate at a pressure of 1.0×10³ Pa to 5.0×10⁷ Pa. The heating time is not particularly limited, but preferably 10 min to 60 min. When the heating time is too short, an insufficient cross-linking may be caused, and when the heating time is too long, each of the materials for a laminate may be deteriorated.

The heating temperature in the above step of curing through cross-linking is preferably 130 to 170°C and further preferably 140 to 160°C. When the heating temperature is too low, the molecular diffusion of the PE is easily proceed and may result in the bloating of the island phase of the PE, and when the heating temperature is too high, the organic peroxide may be quickly decomposed to cause foaming and each of the materials for a laminate may be cured through cross-linking before being laminated to lower the adhesiveness.

The increasing rate of the gel fraction of the EVA can be adjusted by the type of the organic peroxide, the amount thereof to be blended and the like as described below.

Hereinafter will be described in detail materials for a composition relating to a laminate forming sheet used in the cured sheet, the laminate and the process for manufacturing a laminate according to the present invention.

### [Polyethylene]

In the present invention, a polyethylene (PE) is an ethylene-based polymer as defined in JIS and includes homopolymers of ethylene, copolymers of ethylene and 5 mol% or less of an α-olefin having 3 or more carbon atoms such as butene-1, hexene-1, 4-methylpentene-1 and octene-1, and copolymers of ethylene and 1 mol% or less of a non-olefin monomer whose functional group is only having carbon, oxygen and hydrogen (see JIS K 6922-1:1997 appendix). A PE is generally classified in accordance with its density into, for example, a high-density polyethylene (HDPE (or PE-HD)), a low-density polyethylene (LDPE (or PE-LD)) and a linear low-density polyethylene (LLDPE (or PE-LLD)). Any PE may be used, however, it is preferable that the PE be one or more polyethylenes selected from a low-density polyethylene and/or a linear low-density polyethylene, which have a relatively low melting point and a low degree of crystallization,

An LDPE generally has a long branch obtained by polymerizing ethylene in the presence of a radical generator such as an organic peroxide under a high pressure of 100 to 350 MPa, and the density thereof is generally 0.910 g/cm³ or more and less than 0.930 g/cm³. An LLDPE is generally obtained by copolymerizing ethylene and an α-olefin in the presence of a transition metal catalyst such as a Ziegler-type catalyst, a Phillips catalyst and a metallocene-type catalyst, and the density (in accordance with JIS K 7112, the same is applied hereinafter) thereof is generally 0.910 to 0.940 g/cm³, and preferably 0.910 to 0.930 g/cm³. Any of commercially available ones may be appropriately used as them.

### [Ethylene-Vinyl Acetate Copolymer]

In the present invention, the content rate of vinyl acetate in the ethylene-vinyl acetate copolymer (EVA) is usually 20 to 45% by weight based on the weight of the EVA. The lower the content of the vinyl acetate unit in the EVA is, the harder the cured sheet to be obtained tends to become. In the case that the content of vinyl acetate is less than 20% by weight, the cured sheet according to the present invention may have an insufficient transparency and flexibility. On the other hand, in the case of more than 45% by weight, a carboxylic acid, an alcohol, an amine or the like may be generated and tend to cause foaming on the interface with the other member or the like in the laminate.

In the present invention, in order to impart a sufficient flexibility and a moderate hardness to the cured sheet, the content rate of vinyl acetate in the EVA is preferably 20 to 40% by weight, and further preferably 22 to 35% by weight.

The melt flow rate (MFR) (in accordance with JIS-K 7210) of the EVA is preferably 1.0 g/10 min or more. The MFR is further preferably 1.0 to 50.0 g/10 min, and particularly preferably 4.0 to 30.0 g/10 min. The MFR is measured under conditions of 190°C and a loading of 21.18 N.

In the present invention, in addition to the EVA, an ethylene-unsaturated carboxylic acid copolymer such as an ethylene-acrylic acid copolymer and an ethylene-methacrylic acid copolymer, an ionomer of the ethylene-unsaturated carboxylic acid copolymer whose carboxyl groups are partially or completely neutralized with the above metal; an ethylene-unsaturated carboxylate copolymer such as an ethylene-methyl acrylate copolymer, an ethylene-ethyl acrylate copolymer, an ethylene-methyl methacrylate copolymer, an ethylene-isobutyl acrylate copolymer and an ethylene-n-butyl acrylate copolymer; an ethylene-unsaturated carboxylate-unsaturated carboxylic acid copolymer such as an ethylene-isobutyl acrylate-methacrylic acid copolymer and an ethylene-n-butyl acrylate-methacrylic acid copolymer, and an ionomer thereof whose carboxyl groups are partially or completely neutralized with the above metal; an ethylene-polar monomer copolymer such as an ethylene-vinyl ester copolymer such as an ethylene vinyl acetate copolymer; a polyvinylacetal resin (e.g., a polyvinylformal, a polyvinylbutyral (PVB resin) and a modified PVB); and a vinyl chloride resin may be used secondarily.

### [Organic Peroxide]

An organic peroxide can form a cross-linked structure of an EVA or a PE as a cross-linking agent and improve the hardness, adhesiveness and durability of the cured sheet according to the present invention.

Any of organic peroxides may be used as the organic peroxide as long as it is decomposed to generate a radical at a temperature of 100°C or higher. In particular, an organic peroxide having a half-life of 10 h and a decomposition temperature of 70°C or higher is preferable.

From the view point of the heating temperature and storage stability in the process for manufacturing a laminate according to the present invention, examples of the organic peroxide include tert-butylperoxy-2-ethylhexyl monocarbonate, 2,5-dimethyl-2,5-di(tert-butylperoxy)hexane, tert-hexyl peroxypivalate, tert-butyl peroxypivalate, 3,5,5-trimethylhexanoyl peroxide, di-n-octanoyl peroxide, lauroyl peroxide, stearoyl peroxide, 1,1,3,3-tetramethylbutylperoxy-2-ethyl hexanoate, succinic acid peroxide, 2,5-dimethyl-2,5-di(2-ethylhexanoylperoxy)hexane, 1-cyclohexyl-1-methylethylperoxy-2-ethyl hexanoate, tert-hexylperoxy-2-ethyl hexanoate, 4-methylbenzoyl peroxide, tert-butylperoxy-2-ethyl hexanoate, m-toluoyl+benzoyl peroxide, benzoyl peroxide, 1,1-bis(tert-butylperoxy)-2-methylcyclohexane, 1,1-bis(tert-hexylperoxy)-3,3,5-trimethylcyclohexane, 1,1-bis(tert-hexylperoxy)cyclohexane, 2,2-bis(4,4-di-tert-butylperoxycyclohexyl)propane, 1,1-bis(tert-butylperoxy)cyclododecane, tert-hexylperoxyisopropyl monocarbonate, tert-butylperoxy maleic acid, tert-butylperoxy-3,3,5-trimethylhexane, tert-butyl peroxylaurate, 2,5-dimethyl-2,5-di(methylbenzoylperoxy)hexane, tert-butylperoxyisopropyl monocarbonate, tert-hexyl peroxybenzoate, 2,5-di-methyl-2,5-di(benzoylperoxy)hexane. The organic peroxide may be used singly or in combination of two or more.

In particular, tert-butylperoxy-2-ethylhexyl monocarbonate and 2,5-dimethyl-2,5-di(tert-butylperoxy)hexane are preferable as the organic peroxide. These organic peroxides are suitable for setting the gel fraction of the EVA in a given range at the above range of heating temperature during the above heating time in the process for manufacturing a laminate according to the present invention, and enable to obtain a cured sheet with a higher adhesion durability.

The content of the organic peroxide is not particularly limited, however, preferably 0.2 to 4.0 parts by weight and more preferably 0.2 to 3.0 parts by weight based on 100 parts by weight of the mixture of the EVA and the PE. In particular in the case of tert-butylperoxy-2-ethylhexyl monocarbonate, the content thereof is preferably 0.2 to 2.0 parts by weight based on 100 parts by weight of the mixture of the EVA and the PE, and in the case of 2,5-dimethyl-2,5-di(tert-butylperoxy)hexane, the content thereof is preferably 0.5 to 4.0 parts by weight based on 100 parts by weight of the mixture of the EVA and the PE.

In the present invention, a cross-linking aid, an adhesion improver, a plasticizer or the like may be added to the above composition for a laminate forming sheet as necessary in addition to the EVA, the PE and the organic peroxide.

### [Cross-Linking Aid]

A cross-linking aid can enhance the gel fraction of the EVA and improve the adhesiveness and durability of the cured sheet according to the present invention.

The content of the cross-linking aid to be used is generally 10 parts by weight or less, preferably 0.1 to 5 parts by weight and further preferably 0.1 to 2.5 parts by weight based on 100 parts by weight of the mixture of the EVA and the PE. This enables to obtain a cured sheet further excellent in adhesiveness.

Examples of the cross-linking aid (a compound having a radical-polymerizable group as a functional group) include trifunctional cross-linking aids such as triallyl cyanurate and triallyl isocyanurate; and monofunctional or difunctional cross-linking aids of a (meth)acryl ester (e.g., an NK ester). Among them, triallyl cyanurate and triallyl isocyanurate are preferable and triallyl isocyanurate is particularly preferable.

### [Adhesion Improver]

A silane coupling agent can be used as the adhesion improver. This enables to improve the adhesive strength of the cured sheet according to the present invention. Examples of the silane coupling agent include γ-chloropropyltrimethoxysilane, vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-β-(aminoethyl)-γ-aminopropyltrimethoxysilane. These silane coupling agents may be used singly or in combination of two or more. Among them, γ-methacryloxypropyltrimethoxysilane is particularly preferable.

The content of the silane coupling agent is 0.1 to 0.7 part by weight, and particularly preferably 0.3 to 0.65 part by weight based on 100 parts by weight of the mixture of the EVA and the PE.

### [Plasticizer]

As the plasticizer can be used a phosphite such as trisisodecyl phosphite and trisnonylphenyl phosphite and a phosphorous-containing compound such as a phosphate; a polybasic acid ester such as adipic acid ether ester, n-octyl trimellitate, dioctyl phthalate, dihexyl adipate and dibutyl sebacate; a polyalcohol ester such as 2,2,4-trimethyl-1,3-pentanediol diisobutyrate, triethyleneglycol-di-2-ethyl butyrate, tetraethyleneglycol diheptanoate and triethyleneglycol dipelargonate; an epoxydized fatty acid alkyl ester; or the like.

### [Other]

Further, in the present invention, an additive other than the above materials may be used depending on the application of the laminate forming sheet. For example, in the case where the laminate forming sheet is used for an intermediate film for a laminated glass or a solar cell sealing film, various additives such as an acryloxy group-containing compound, a methacryloxy group-containing compound, an epoxy group-containing compound, an ultraviolet absorber, a photostabilizer and/or an antioxidant may be added as necessary in order to improve or adjust various physical properties (mechanical strength, adhesiveness, optical properties such as transparency, heat resistance, light resistance, cross-linking rate, etc.).

### [Process for Manufacturing Laminate Forming Sheet]

As described above, in order to obtain the cured sheet according to the present invention having a sea-island structure in which the EVA component constitutes a sea phase and the PE component constitutes an island phase, a laminate forming sheet (uncured) is usually manufactured so as to have a similar sea-island structure. The process for manufacturing a laminate forming sheet is not particularly limited, however, particularly in the case that the blending ratio of the PE is high, the above-described sea-island structure is less likely to be formed, and therefore it is preferable to control conditions for a step of kneading the composition for a laminate forming sheet.

For example, in kneading the EVA and the PE, they are preferably kneaded under conditions that the viscosity of the PE (V_{PE} [Pa·s]) is 0.1 to 20 times of the viscosity of the EVA (V_{EVA} [Pa·s]). In the case where the EVA and the PE are kneaded under the conditions, a composition having a sea-island structure with a higher blending ratio of the PE can be obtained. Particularly in the case of a composition in which the blending ratio of the PE is higher than that of the EVA, regarding to the above kneading conditions, the viscosity of the PE (V_{PE} [Pa·s]) is further preferably more than 1 time and 20 times or less, further preferably 2 to 15 times, and particularly preferably 4 to 13 times of the viscosity of the EVA (V_{EVA} [Pa·s]). This leads to the fact that the EVA component is more flowable than the PE component, and therefore the EVA component can flow well even in a small blending amount of the EVA, so that only the EVA is likely to form a continuous phase. This enables to obtain a composition having a sea-island structure with a higher blending ratio of the PE.

In addition, the viscosity of the EVA (V_{EVA}) is preferably 1,000 to 50,000 Pa·s, and further preferably 2,000 to 20,000 Pa·s. On the other hand, the viscosity of the PE (V_{PE}) is preferably 20, 000 to 120, 000 Pa·s, and further preferably 30,000 to 50,000 Pa·s. The viscosities of these resins can be measured, for example, by using a capillary rheometer at a shear rate of 6.1 s⁻¹ at an actual processing temperature. The above viscosity ratio can be calculated from these viscosities.

The shear rate in kneading the EVA and the PE is preferably 10 to 1,500 s⁻¹ as conditions for forming the above sea-island structure. This enables to form the island phase of the PE more compactly and obtain a composition having a sea-island structure with a higher blending ratio of the PE. Regarding to the above kneading conditions, the shear rate is further preferably 100 to 1,000 s⁻¹, and particularly preferably 200 to 800 s⁻¹.

In order to obtain a preferred shape of the island phase of the PE in the sea-island structure of the above cured sheet, it is preferable to set the average diameter ((average major axis (l) + average minor axis (d)) / 2) of the island phase of the PE to 40 µm or less, further preferably 5 to 30 µm, and particularly preferably 10 to 20 µm and to set the average aspect ratio (average major axis (l) / average minor axis(d)) of the island phase of the PE to 40 or less, further preferably 1 to 30, and particularly preferably 1 to 10 at the stage of the composition for a laminate forming sheet. These values can be measured and calculated similarly to the shape of the island phase of the PE in the cured sheet.

The step of kneading may be performed with any device. For example, an EVA, a PE and an organic peroxide and as necessary the above materials are charged into a super mixer (high-speed flow mixer), a double-screw kneader, a planetary gear-type kneader, a single-screw extruder or the like, and preferably kneaded under the above conditions.

The laminate forming sheet can be obtained by forming a sheet-like film with the composition for a laminate forming sheet obtained in the step of kneading described above.

That is, the laminate forming sheet can be manufactured by using a method in which the above composition is subjected to secondary kneading such as roll kneading as necessary and thereafter is molded by using a common extrusion molding, a calender-molding (calendering) or the like to provide a sheet-like object. The heating temperature at film-forming is preferably a temperature at which the organic peroxide does not react or hardly reacts. For example, the heating temperature is preferably 50 to 120°C, and particularly preferably 40 to 100°C. The thickness of the laminate forming sheet is not particularly limited and can be set appropriately depending on the application. The thickness of the laminate forming sheet is generally in a range of 50 µm to 2 mm.

### [Application]

The cured sheet according to the present invention may be for any application as long as it is a cured sheet constituting a laminate as described above, however, the cured sheet is preferably a cured sheet used in the outdoor environment, in which weatherability and durability are required, and particularly preferably a cured product of an intermediate film for a laminated glass or a solar cell sealing film because of being imparted heat resistance and the like and being excellent in adhesion durability due to containing a PE.

The cured product of an intermediate film for a laminated glass is usually a cured product which is sandwiched between two transparent substrates and bonding integrates the laminated glass.

In manufacturing a laminated glass, for example, a process as shown in Figure 2 in which an intermediate film 12 (the above laminate forming sheet (uncured)) is sandwiched between two transparent substrates 11A and 11B is used, and the obtained laminate is degased followed by being pressed under heating. These steps are performed, for example, by using a vacuum bag method, a nip roll method or the like. As a result, the intermediate film 12 can be cured to bonding integrate the intermediate film 12 to the transparent substrates 11A and 11B together. In order that the intermediate film 12 is the cured sheet according to the present invention and the laminated glass is the laminate according to the present invention, it is preferable to manufacture conforming to the above-described conditions for a process for manufacturing a laminate. For example, the above laminate is press-adhered in advance at a temperature of 80 to 120°C, heat-treated at 130 to 175°C for 10 to 60 min so that the gel fraction of the EVA in the laminate forming sheet 5 min after the initiation of heating becomes 15 to 70%. The heat treatment may be performed under an increased pressure. In this case, it is preferable to perform the heat treatment while pressuring the laminate at a pressure of 1.0×10³ Pa to 5.0×10⁷ Pa. Cooling after the cross-linking is generally performed at a room temperature and particularly the quicker the cooling, the more preferable.

As the transparent substrate may be used, for example, a glass plate such as a silicate glass, an inorganic glass plate and an uncolored transparent glass plate may be used, and in addition a plastic film may also be used. Examples of the plastic film include a polyethylene terephthalate (PET) film, a polyethylene naphthalate (PEN) film and a polyethylene butyrate film, and a PET film is preferable. The thickness of the transparent substrate is typically approximately 0.05 to 20 mm.

The cured product of a solar cell sealing film is usually a cured product which seals a solar cell between a face side transparent protective member and a back side protective member to adhere the solar cell module to integrate. In the present invention, the side of a solar cell to which the light is irradiated (the side of the light-receiving surface) is referred to as a "face side" and the side of a solar cell opposite to the light-receiving surface is referred to as a "back side".

In manufacturing a solar cell module, for example, is used a process as shown Figure 3 in which a face side transparent protective member 21, a face side sealing film 23A, a solar cell 24, a back side sealing film 23B and a back side protective member 22 are laminated and the sealing films 23A and 23B are cured through cross-linking with a conventional method such as heating and pressurizing. In this case, the above laminate forming sheet (uncured) is used as the face side sealing film 23A and/or the back side sealing film 23B. In the heating and pressurizing, the face side sealing film 23A and the back side sealing film 23B are cross-linked, and thereby the face side transparent protective member 21, the back side protective member 22 and the solar cell 24 can be integrated together via the face side sealing film 23A and the back side sealing film 23B to seal the solar cell 24. In order that the cured product of the face side sealing film 23A and/or the back side sealing film 23B is/are the cured sheet according to the present invention and the solar cell module is the laminate according to the present invention, it is preferable to manufacture conforming to the above-described conditions for a process for manufacturing a laminate. For example, the above laminate is press-adhered under heating in a vacuum laminator under conditions of a temperature of 135 to 175°C, further preferably 140 to 175°C and particularly preferably 155 to 175°C, a degassing time of 0.1 to 5 min, a pressing pressure of 0.1 to 1.5 kg/cm² and a pressing time of 10 to 60 min so that the gel fraction of the ethylene-vinyl acetate copolymer in the laminate forming sheet 5 min after the initiation of heating becomes 15 to 70%.

The cured sheet according to the present invention (a cured product of a solar cell sealing film) may be a cured product of a sealing film for a thin film solar cell such as a thin film silicon-based solar cell, a thin film amorphous-silicon-based solar cell and a copper-indium-selenide (CIS)- based solar cell, not only a cured product of a solar cell sealing film using a monocrystalline or polycrystalline silicon-based solar cell as shown in Figure 2. In this case, for example, examples of the structure include a structure in which a thin film solar cell element layer is formed on the surface of a face side transparent protective member such as a glass substrate, a polyimide substrate and a fluorine resin transparent substrate by using a chemical vapor deposition method or the like, on which a back side sealing film and a back side protective member are laminated and bonding integrated together; a structure in which a face side sealing film and a face side transparent protective member are laminated on a solar cell element formed on the surface of a back side protective member and bonding integrated together; and a structure in which a face side transparent protective member, a face side sealing film, a thin film solar cell element, a back side sealing film and a back side protective member are laminated in this order and bonding integrated together.

It is desirable that the face side transparent protective member 21 used in the present invention be a glass substrate which is usually a silicate glass. The thickness of the glass substrate is typically 0.1 to 10 mm and preferably 0.3 to 5 mm. The glass substrate may be chemically tempered or thermally tempered one.

A plastic film of a polyethylene terephthalate (PET) or the like is preferably used as the back side protective member 22 used in the present invention. In view of heat resistance and moisture-heat resistance, a fluorinated polyethylene film, particularly a film in which a fluorinated polyethylene film/Al/ a fluorinated polyethylene film are laminated in this order may also be used.

### Examples

Hereinafter, the present invention will be described with reference to Examples.

### [Examples 1 to 17, Comparative Examples 1 to 5]

### (1) Preparation of Sheet Samples for Forming Laminate and Cured Sheet Samples

An EVA, a PE and an organic peroxide were kneaded (kneading temperature: 120°C) in respective blending ratios shown in Table 1 to prepare a mixture composition of an EVA and a PE having a sea-island structure in which the EVA was a sea phase and the PE was an island phase. The composition was then calender-molded (molding temperature: 85°C) to prepare each sheet sample for forming a laminate (thickness: 0.5 mm and 2.0 mm).

Each of the above-produced sheet samples for forming a laminate (100 mm × 100 mm × 2.0 mm thickness) was then sandwiched between two PET templates (thickness: 0.75 µm), temporarily press-adhered at 100°C, and heated in an oven at the temperature shown in Table 1. Two samples were prepared under the same conditions, and one of them was taken out 5 min after heating, which was used as a sample for measuring gel fraction, and the other sample was heated for the time shown in Table 1, which was used as a cured sheet sample.

### (2) Evaluation Method

### (i) Gel Fraction

In a 200 mesh wire-netting bag was weighed 1 g of each of the samples for measuring gel fraction, which was extracted with a solvent (xylene) at 145°C for 6 h using a Soxhlet extractor, and the residue was dried and weighed. The gel fraction (%) of the EVA was calculated from the initial weight and the dry weight of the extraction residue ((dry weight of extraction residue / initial weight) × 100).

### (ii)Sea-island Structure

Each cured sheet sample was cross-sectioned using Microtomes (from Leica Biosystems Nussloch GmbH) and elastic modulus mapping was carried out for the cross-section with an AFM (atomic force microscope) (from TOYO Corporation), and the sea-island structure of the EVA and the PE was observed. The case that the EVA was a sea phase (continuous phase) and the PE was an island phase was evaluated as ○ and the case that the PE changed to a continuous phase (including a co-continuous phase) was evaluated as ×.

### (iii) Average Diameter and Average Aspect Ratio of Island Phase of PE

Among the above cured sheet samples, the one in which an island phase of the PE was confirmed was subjected to a binarization image processing (from the view point of resolution, an island phase whose major axis was 1.2 µm or less was regarded as a noise and excluded from the calculation), the major axis and minor axis of an island phase present in an area of 2500 µm² in the case of an AFM (atomic force microscope) image or 4900 µm² in the case of an optical microscope image were measured, and from the average value thereof were determined the average diameter ((average major axis (l) + average minor axis (d) / 2) and the average aspect ratio (average major axis (l) / average minor axis (d)).

### (iv) Storage Elastic Modulus

Each of the cured sheet samples with a thickness of 2 mm was punched into a circle with a diameter of 6 mm and used as a sample for evaluating storage elastic modulus. The obtained sample was measured with ARES (from TA Instruments) under conditions of 30°C, 10 Hz and 0.1% strain, and the storage elastic modulus of each sample was determined. The case that the storage elastic modulus was 10 MPa or less was evaluated as ○, and the case of more than 10 MPa as ×.

### (v) Initial Adhesive Strength

Each sheet sample for forming a laminate (100 mm × 100 mm × 0.5 mm thickness) produced above was sandwiched with one side on a PET template film (thickness: 0.75 µm) and the other side on a plate glass (thickness: 3.2 mm), temporarily press-adhered at 100°C, and heated in an oven at the temperature shown in Table 1 to produce a sample for evaluating initial adhesive strength. The obtained sample was evaluated for the initial adhesive strength in a 180° peel test (conforming to JIS K 6584: 1994, 30°C, tensile speed: 100 mm/min) with a tensile tester (from INSTRON) to peel a part between the glass plate and the laminate forming sheet. The case that the initial adhesive strength was 20 N/cm or more was evaluated as ⊚, the case of less than 20 N/cm and 15 N/cm or more as ○, and the case of less than 15 N/cm as ×.

### (vi) Adhesion Durability (Adhesive Strength after Durability Test)

The same sample as the above-produced sample for evaluating initial adhesive strength was subjected to a durability test (being left under conditions of 85°C and 85% RH for 1500 h), and thereafter the adhesive strength was evaluated as described above. Regarding to adhesion durability, the case that the adhesive strength after the durability test was 9.8 N/cm or more was evaluated ○, and the case of less than 9.8 N/cm as ×.

### (Evaluation Result)

The evaluation results are shown in Table 1.

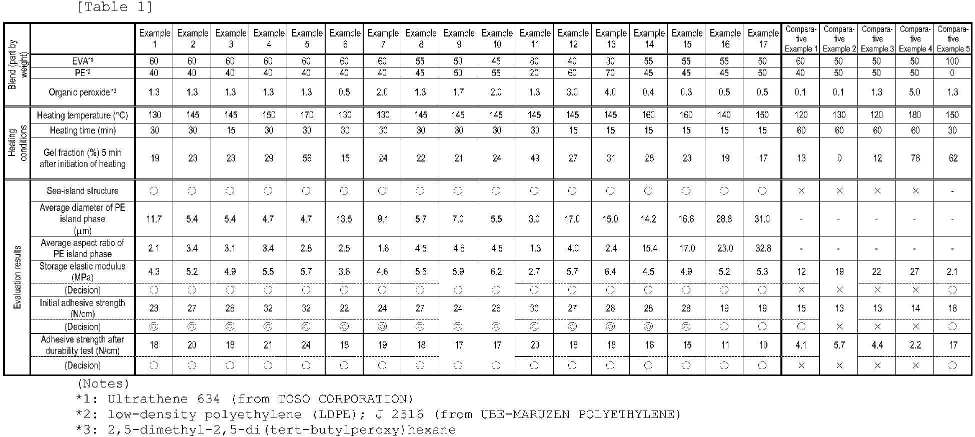

As shown in Table 1, it was found that the cured sheets in Examples 1 to 17 having a sea-island structure in which the EVA was a sea phase and the PE was an island phase had an elastic modulus and adhesion durability similar to those of the cured sheet containing an EVA only (Comparative Example 5), and had a more excellent initial adhesive strength, adhesion durability and flexibility than those of the cured sheets of Comparative Examples 1 to 4 containing a mixture of an EVA and a PE not having a sea-island structure.

In addition, even though the above sea-island structure was present at the stage of the laminate forming sheet (uncured), the PE changed to a continuous phase in the case that the gel fraction of the EVA 5 min after the initiation of heating was less than 15%, and adhesion failure occurred due to foaming in the case of more than 70%, and it was thus demonstrated that the laminate according to the present invention having the cured sheet according to the present invention can be obtained by using the process for manufacturing a laminate according to the present invention.

Note that the present invention is not limited to the constitution of the above embodiment and Examples and can be variously modified within the gist of the invention.

### Industrial Applicability

According to the present invention, there can be provided a laminated glass or a solar cell module excellent in weatherability and durability.

### Reference Signs List

- 11A, 11B: transparent substrate
- 12: intermediate film
- 21: face side transparent protective member
- 22: back side protective member
- 23A: face side sealing film
- 23B: back side sealing film
- 24: solar cell

## Claims

1. A cured sheet constituting a laminate, wherein
the cured sheet is prepared by curing through cross-linking a laminate forming sheet comprising a composition containing an ethylene-vinyl acetate copolymer, a polyethylene and an organic peroxide;
a weight ratio of the ethylene-vinyl acetate copolymer (EVA) to the polyethylene (PE) (EVA:PE) is in a range of 3:7 to 8:2; and
the cured sheet has a sea-island structure in which the ethylene-vinyl acetate copolymer constitutes a sea phase and the polyethylene constitutes an island phase.

2. The cured sheet according to claim 1, wherein an average diameter ((average major axis (l) + average minor axis (d)) / 2) of the island phase of the polyethylene is 40 µm or lees.

3. The cured sheet according to claim 1 or 2, wherein an average aspect ratio (average major axis (l) / average minor axis (d)) of the island phase of the polyethylene is 40 or less.

4. The cured sheet according to any one of claims 1 to 3, wherein the weight ratio of the ethylene-vinyl acetate copolymer (EVA) to the polyethylene (PE) (EVA:PE) is in a range of 3:7 to 6:4.

5. The cured sheet according to any one of claims 1 to 4, which is a cured product of an intermediate film for a laminated glass or a solar cell sealing film.

6. A laminate having the cured sheet according to any one of claims 1 to 5.

7. The laminate according to claim 6, which has a structure in which the cured sheet is sandwiched between at least two substrates.

8. The laminate according to claim 6 or 7, which is a laminated glass or a solar cell module.

9. A process for manufacturing the laminate according to any one of claims 6 to 8, comprising the steps of:
laminating a laminate forming sheet and another material for a laminate to form an uncured laminate, wherein the laminate forming sheet comprises a composition containing an ethylene-vinyl acetate copolymer, a polyethylene and an organic peroxide; a weight ratio of the ethylene-vinyl acetate copolymer (EVA) to the polyethylene (PE) (EVA:PE) is in a range of 3:7 to 8:2; and the laminate forming sheet has a sea-island structure in which the ethylene-vinyl acetate copolymer constitutes a sea phase and the polyethylene constitutes an island phase; and
heating the uncured laminate to cure the laminate forming sheet through cross-linking, wherein
the heating is performed under a temperature condition of 130 to 175°C so that a gel fraction of the ethylene-vinyl acetate copolymer in the laminate forming sheet 5 min after the initiation of heating is 15 to 70%.

10. The process for manufacturing a laminate according to claim 9, wherein the organic peroxide is t-butylperoxy-2-ethylhexyl monocarbonate or 2,5-dimethyl-2,5-di(tert-butylperoxy)hexane.

11. The process for manufacturing a laminate according to claim 9 or 10, wherein a content of the organic peroxide is 0.2 to 4.0 parts by weight based on 100 parts by weight of a mixture of the ethylene-vinyl acetate copolymer and the polyethylene.
